# EUROPEAN PATENT APPLICATION

(11) **EP 0 833 380 A2**
(43) Date of publication of application: **01.04.1998**
(21) Application number: 97307556.7
(22) Date of filing: 26.09.1997
(51) Int. Cl.: H01L 21/336, H01L 29/78, H01L 21/265

(54) **Improvements in or relating to mosfet transistors**

(30) Priority: 27.09.1996 US 26840 P
(71) Applicant: TEXAS INSTRUMENTS INCORPORATED, Dallas Texas 75265 (US)
(72) Inventor: Holloway, Thomas C., Murphy, Texas 75094 (US)
(74) Representative: Williams, Janice

(57) **Abstract**

The process flow in the fabrication of MOSFETs having a LDD (11,13) is altered by using a combination of arsenic and phosphorus (7) to tailor the lateral profile to meet both series resistance and channel hot carrier requirements. In this process flow, the relatively higher dose arsenic controls the series resistance and the lighter phosphorus dose sets the lateral junction profile. Therefore, a profile intermediate the arsenic only and the phosphorus only can be achieved. In forming a LDD (11, 13) in embodiments of the present invention, the arsenic implant dose is relatively high. The lateral extent of the LDD (11,13) is varied to meet the hot carrier lifetime by varying the lighter phosphorus implant dose. This procedure is achieved using standard process technology.

## Description

### FIELD OF THE INVENTION

The present invention relates generally to fabricating MOSFET transistors, and in a particular example to an improved n-channel MOSFET lightly doped drain.

### BACKGROUND OF THE INVENTION

The continued reduction in the geometry of MOSFET transistors has resulted in the requirement of continually shorter gate lengths (<0.3µm), This geometry reduction has also required a reduction of lateral diffusion of the source/drain under the edge of the gate electrode. For transistor designs using a lightly doped drain extender (LDD), this requires (a) reducing the diffusion, (b) reducing the implant dose or (c) changing the implant species from phosphorus to arsenic. Reduction of the diffusion below a minimum amount required for dopant activation is a limitation to such diffusion reduction. Reduction of the implant dosage results in an increase in source/drain resistance. Switching from a phosphorus dopant to an arsenic implanted LDD greatly decreases the lateral overlap but this reduction in lateral diffusion results in a sharper lateral junction profile which, in turn, results in a degraded hot carrier reliability if doping levels are maintained high to minimize source/drain resistance. Even added diffusion with an arsenic only LDD dose not soften the lateral junction profile due to the concentration dependent diffusivity of arsenic. The overall problem is one in being able to tailor the lateral doping profile to an intermediate value between that obtained using phosphorus or arsenic alone.

Large angle tilt implanted drain (LATID) structures are an alternate solution to the same problem discussed above. However, this implant capability is not common in present-day manufacturing and is therefor impractical.

The current practice for fabrication of n-channel LDD implants in MOSFETs is to implant either arsenic or phosphorus after formation of the gate electrode, but before sidewall spacer formation which precedes source/drain formation. The problems resulting from this procedure are enumerated above with regard to the dimensional requirements of present and future MOSFETs. It is therefore apparent that improved procedures are required for the next generation of MOSFET devices having a lightly doped drain extender.

### SUMMARY OF THE INVENTION

Respective aspects of the present invention are set forth in claims 1 and 8.

In accordance with another aspect of the invention, the process flow in the fabrication of MOSFETs having a LDD is altered by using a combination or arsenic and phosphorus to tailor the lateral profile to meet both series resistance and the lighter phosphorus dose sets the lateral junction profile. Therefore, a profile intermediate the arsenic only and the phosphorus only can be achieved. In forming a LDD in embodiments of the present invention, the arsenic implant dose is relatively high and is equal to or greater than 6 x 10¹³ cm⁻². The lateral extent of the LDD is varied to meet the hot carrier lifetime by varying the lighter phosphorus implant dose, the dose being less than 1 x 10¹⁴ cm⁻² with a preferred value of 6 x 10¹³ cm⁻². This procedure is achieved using standard process technology.

Briefly, a MOSFET may be fabricated in accordance with the present invention by providing a doped region of semiconductor material having a gate oxide layer thereon. The gate electrode, which is generally highly doped polycrystalline silicon (polysilicon), is then deposited and patterned in a standard manner. The LDD implant is then provided by implanting arsenic ions at normal incidence to the wafer surface with 100 KeV energy and 1.0 x 10¹⁴ cm⁻² total dose, followed (or preceded) by implanting phosphorus ions at normal incidence to the wafer with 500 KeV energy and 6.0 x 10¹³ cm⁻² total dose. Both implants are performed through a 20 to 30 nanometer thick screen oxide. A sidewall spacer is then formed on the sidewalls of the gate electrode and source/drain implants and diffusion/anneal are provided in standard manner. The results is a LDD wherein the series resistance and lateral junction profile are controlled by tailoring the dosage of arsenic and phosphorus.

### BRIEF DESCRIPTION OF THE DRAWINGS

The present invention will now be further described by way of example, with reference to the accompanying drawings in which:
FIGURES 1a to 1c demonstrate a portion of the process flow in fabrication of a MOSFET having a LDD fabricated in accordance with an embodiment of the invention;
FIGURE 2 is a graph showing lateral extent of the combination implant as a function of arsenic and phosphorus dosage; and
FIGURE 3 is a graph showing source/drain resistance as a function of arsenic and phosphorus dosage.

### DESCRIPTION OF THE PREFERRED EMBODIMENT

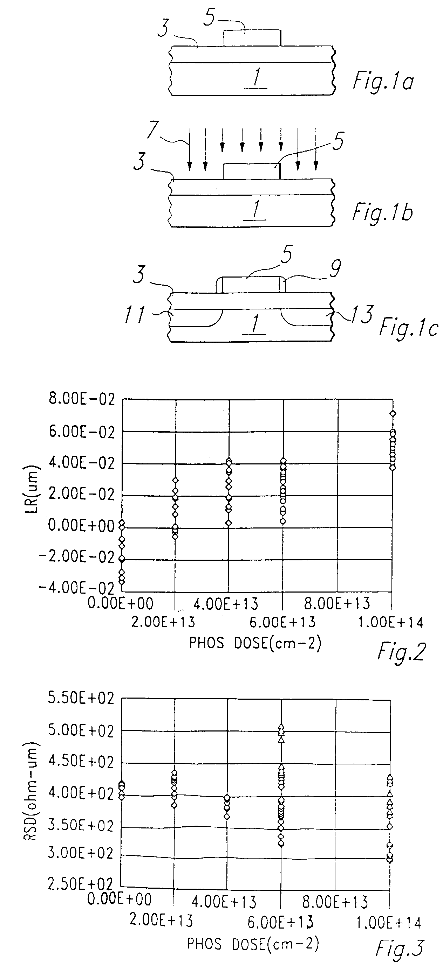

Referring to FIGURE 1a, there is shown a partially fabricated MOSFET and particularly an NMOS transistor having a body of semiconductor material 1 which is doped p-type. A gate oxide 3 is disposed over the upper surface of the semiconductor material and a polysilicon gate electrode 5 which is highly doped and which can be n-type or p-type and is usually n-type for n-channel transistors, has been formed over the gate oxide. A LDD implant of phosphorus and arsenic 7 is then provided as shown in FIGURE 1b. The LDD regions (not shown) are formed by implanting arsenic ions at normal incidence to the wafer surface with 100 KeV energy and 1.0 x 10¹⁴ cm⁻² total dose. Both implants are performed through a 20 to 30 nanometer thick screen oxide and a sidewall spacer 9 is then formed in standard manner on the sidewalls of the gate electrode 5 with source/drain implants 11 and 13 and diffusion/anneal then taking place in standard manner to provide the structure as shown in FIGURE 1c. Completion of fabrication of the MOSFET device then proceeds in standard manner with fabrication of contacts to the source/drain regions 11 and 13 and to the gate electrode 5.

Referring now to FIGURE 2, there is a graph showing lateral extent of an LDD in an NMOS transistor as a function of the arsenic and phosphorus dosage. The graph shows lateral extent (LR) in micrometers vs. phosphorus dosage in cm⁻² with diamonds representing an arsenic dosage of 1 x 10¹⁴ and circles representing no arsenic being used. This graph provides many examples of the use of the invention herein and demonstrates how the lateral extent of the combination implant can be varied over a wide range by varying the phosphorus dose.

Referring now to FIGURE 3, there is a graph showing source/drain resistance of an NNOS transistor as a function of LDD doses of arsenic and phosphorus. The graph shows source/drain resistance in ohm-micrometers vs. phosphorus dosage in cm⁻² with diamonds representing an arsenic dosage of 1 x 10¹⁴ and triangles representing no arsenic being used. This graph provides many examples of the use of the invention herein and demonstrates how the low source/drain resistance can be achieved thereby.

Though the invention has been described with respect to specific preferred embodiments thereof, many variations and modifications will immediately become apparent to those skilled in the art.

## Claims

1. A method of fabricating an NMOS transistor comprising the steps of:
providing a partially fabricated NMOS transistor having a body of semiconductor material doped with an n-type material, a gate oxide thereover and a gate electrode disposed over said gate oxide;
forming a lightly doped drain including the step of implanting a combination of a dose of arsenic and a dose of phosphorus smaller than the dose of arsenic; and
completing fabrication of said NMOS transistor.

2. The method of Claim 1 further comprising the step of selecting the lateral profile of said lightly doped drain to meet both series resistance and channel hot carrier requirements by adjusting the ratio of said arsenic to said phosphorus.

3. The method of Claim 1 wherein said step of implanting a combination of arsenic and phosphorus comprises implanting a dose of arsenic that is equal to or greater than 6 x 10¹³ cm⁻².

4. The method of Claim 2 wherein said step of implanting a combination of arsenic and phosphorus comprises implanting a dose of arsenic that is equal to or greater than 6 x 10¹³ cm⁻².

5. The method of Claim 3 or Claim 4, wherein said step of implanting a combination of arsenic and phosphorus comprises implanting a dose of arsenic that is about 1 x 10¹⁴ cm⁻².

6. The method of any preceding Claim, wherein said step of implanting a combination of arsenic and phosphorus comprises implanting a dose of phosphorus that is less than 1 x 10¹⁴ cm⁻².

7. The method of any of Claims 1 to 5 wherein said step of implanting a combination of arsenic and phosphorus comprises implanting a said dose of phosphorus that is about 6 x 10₁₃ cm⁻².

8. A method of fabricating an NMOS transistor comprising the steps of:
providing a partially fabricated NMOS transistor having a body of semiconductor material doped with n-type material, a gate oxide thereover and a gate electrode disposed over said gate oxide;
forming a lightly doped drain including the step of implanting a combination of a dose of arsenic at normal incidence to the surface of said partially fabricated NMOS transistor containing said gate oxide with about 100 KeV energy and a dose of phosphorus smaller than the dose of arsenic with about 50 KeV energy, thereby selecting the lateral profile of said lightly doped drain to meet both series resistance and channel hot carrier requirements by adjusting the ratio of said arsenic to said phosphorus; and
completing fabrication of said NMOS transistor.

9. The method of Claim 8 wherein said step of implanting a combination of arsenic and phosphorus comprises implanting a dose of arsenic that is equal to or greater than 6 x 10¹³ cm⁻² and a dose of phosphorus that is less than 1 x 10¹⁴ cm⁻².
